# EUROPEAN PATENT SPECIFICATION

(11) **EP 3 414 366 B1**
(45) Date of publication and mention of the grant of the patent: **29.03.2023**
(21) Application number: 17711323.0
(22) Date of filing: 02.02.2017
(51) Int. Cl.: H05B 6/06, C30B 23/06, C30B 25/12, C23C 16/458, C23C 16/46, H05B 6/10

(54) **INDUCTIVELY HEATABLE SUSCEPTOR AND EPITAXIAL DEPOSITION REACTOR**
INDUKTIV ERWÄRMBARER SUSZEPTOR UND EPITAKTISCHER ABSCHEIDUNGSREAKTOR
SUSCEPTEUR POUVANT ÊTRE CHAUFFÉ PAR INDUCTION ET RÉACTEUR DE DÉPÔT EPITAXIAL

(30) Priority: 08.02.2016 IT UB20160556
(43) Date of publication of application: 19.12.2018
(73) Proprietor: LPE S.p.A., 20021 Baranzate (MI) (IT)
(72) Inventor: OGLIARI, Vincenzo, 20021 Baranzate (MI) (IT); FORZAN, Michele, 20021 Baranzate (MI) (IT); PRETI, Silvio, 20021 Baranzate (MI) (IT)
(74) Representative: De Ros, Alberto
(86) International application number: PCT/IB2017/050565
(87) International publication number: WO 2017/137872

(56) References cited:
- WO-A1-01/55479
- WO-A1-2006/108783
- WO-A2-2009/049020
- CN-A- 103 540 912
- US-A- 5 897 380
- US-A- 6 031 211
- US-A- 6 118 100
- US-A1- 2002 106 826
- US-A1- 2013 061 805
- US-A1- 2013 125 820

## Description

### FIELD OF THE INVENTION

The present invention concerns a susceptor with heated stud and an epitaxial deposition reactor that comprises such a susceptor.

### STATE OF THE ART

In the reaction chamber of an epitaxial deposition reactor the disc-shaped susceptor, which is used to horizontally support the substrates, can be heated by electromagnetic induction through a flat inductor arranged parallel to the susceptor in the vicinity of the lower horizontal wall of the reaction chamber; these are so-called epitaxial reactors with "induction heating"; in general, the susceptor is made to rotate about its axis of (substantial) symmetry during the epitaxial deposition processes through a drive shaft mechanically coupled with the susceptor.

The electromagnetic field generated by such a flat inductor is not uniform and, consequently, the heat generated inside the susceptor is not uniform. But the susceptor is made entirely of material that is a fair heat conductor, in general graphite, and therefore the temperature of the upper face of the susceptor (on which, in general, one or more substrates rest) is quite uniform.

However, the electromagnetic field generated by such a flat inductor is very weak at the axis of the inductor (which corresponds to the axis of the susceptor); as a result the temperature of the central zone of the upper face of the susceptor (on which, in general, one or more substrates rest) is a little lower than the rest of the upper face of the susceptor.

Such an effect is particularly troublesome in the case of susceptors adapted to support a single substrate.

The problem of the uniformity of the temperature of the susceptor is more felt when a higher quality is required of the layers of semi-conductive material deposited on the substrates. Possible important and undesired effects of such lack of uniformity of temperature include: non-uniformity of the thickness of the layer deposited on the substrate, non-uniformity of the electrical properties of the layer deposited on the substrate, crystallographic defects in the layer deposited on the substrate, occurrence of stresses inside the substrate and/or the layer deposited on the substrate. Relevant prior art documents are US 2002/106826 A1 and US 6 031 211 A.

### SUMMARY

The Applicant has thus set itself the task of improving the prior art and of solving the problems outlined above.

Such a task is substantially achieved thanks to the susceptor having the technical features set out in the attached claims.

The basic idea of the present invention is to provide a susceptor comprising a disc-shaped portion and a cylindrical or conical portion - the disc-shaped portion is used to (directly or indirectly) support substrates to be subjected to epitaxial deposition inside a reaction chamber of an epitaxial deposition reactor and the cylindrical or conical portion is used to contribute to the heating of the disc-shaped portion.

Thanks to this configuration of the susceptor, it is possible to heat the disc-shaped portion to a very uniform temperature; In fact, for example, the heating of the susceptor can be obtained through a first inductor adapted to directly heat (in particular by induction) the disc-shaped portion, in particular its outer annular zone, and a second inductor adapted to directly heat (in particular by induction) the cylindrical or conical portion and to indirectly heat (in particular by conduction) the disc-shaped portion, in particular its central zone.

An aspect of the present invention is also an epitaxial deposition reactor that comprises such a susceptor.

### LIST OF FIGURES

The present invention will become clearer from the following detailed description to be considered together with the attached drawings in which:
Fig. 1 shows a schematic vertical section view of a susceptor according to the present invention inside a reaction chamber of an epitaxial reactor,
Fig. 2 shows an (ideal) temperature diagram relating to the susceptor of Fig. 1 due to two distinct inductors,
Fig. 3 schematically shows the structure of a first embodiment of a susceptor according to the present invention,
Fig. 4 schematically shows the structure of a second embodiment of a susceptor according to the present invention,
Fig. 5 schematically shows the structure of a third embodiment of a susceptor according to the present invention,
Fig. 6 shows a (detailed) schematic vertical section view of a first implementation of the susceptor of Fig. 1,
Fig. 7 shows a (detailed) schematic vertical section view of a second implementation of the susceptor of Fig. 1, and
Fig. 8 shows (real) temperature diagrams relating to a susceptor very similar to that of Fig. 1 in five different heating conditions.

As can be easily understood, there are various ways of practically carrying out the present invention that is defined in the attached claims.

### DETAILED DESCRIPTION

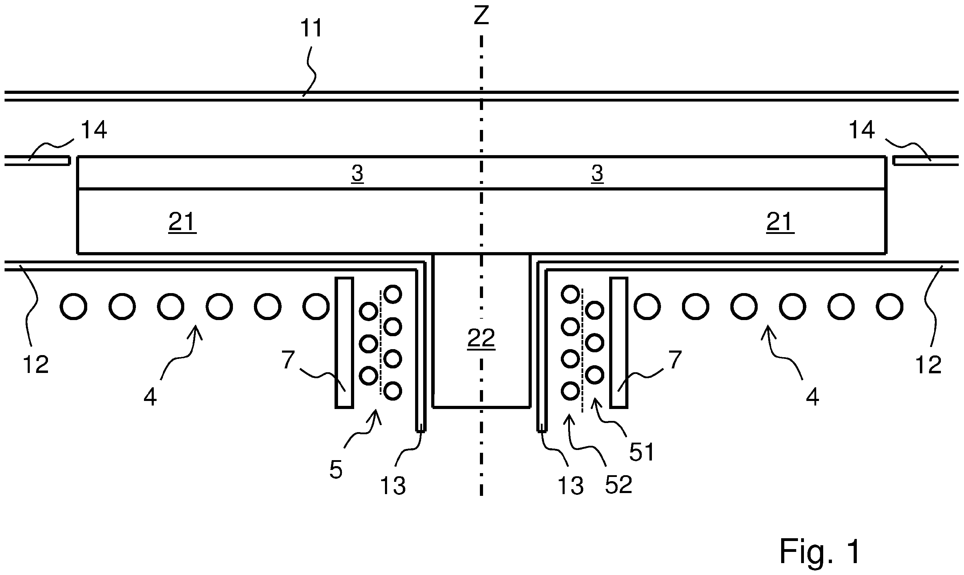

Fig. 1 shows a schematic vertical section view of a susceptor according to the present invention in horizontal position inside a reaction chamber of an epitaxial reactor.

In this example, the susceptor comprises a disc-shaped portion 21 made entirely of graphite (possibly totally or partially coated with SiC and/or TaC) and a cylindrical portion 22 made entirely of graphite (possibly totally or partially coated with SiC or TaC), and is associated with a disc-shaped support 3 for substrates made entirely of graphite (possibly totally or partially coated with SiC and/or TaC) - such a support may be considered part of the susceptor.

The graphite that is used to make the susceptors and their components is isotropic and isostatic, often has a density of 1.5-2.5 g/cm³, an electrical resistivity of 5-15 microOhm*m (therefore it can be said to be a material with fair electrical resistivity), and heat conductivity of 50-200 W/m/K (therefore it can be said to be a material with fair heat conductivity).

In this example of Fig. 1, the reaction chamber is box-shaped and is made entirely from quartz (for example transparent quartz material possibly totally or partially coated with material that reflects infrared rays); in Fig. 1, it is possible to see partially an upper horizontal wall 11 of the chamber, partially a lower horizontal wall 12 of the chamber, entirely a vertical sleeve 13 of the chamber joined to the wall 12 at a hole thereof; in Fig. 1, it is also possible to partially see a horizontal "liner" 14 of the chamber that in part precedes and in part follows the portion 21 (this is a component that is used to guide the gaseous flow, of reaction gases and then of exhaust gases, in particular to confine it at its bottom).

The portion 21 and the support 3 are inside the chamber, in particular in its "reaction and deposition" zone, between the wall 11 and the wall 12, but closer to the wall 12 so that the reaction gases flow between the upper surface of the support 3 and the lower surface of the wall 11; the "liner" 14 is horizontally aligned with the support 3 at its top and contributes to defining a flow channel of the reaction gases; the portion 22 is inside the sleeve 13.

In this example, the axis of (substantial) symmetry of the portion 21 coincides with the axis of (substantial) symmetry of the portion 22, with the axis of (substantial) symmetry of the support 3 and with a vertical axis Z of the reaction chamber, in particular the axis of (substantial) symmetry of the sleeve 13.

In this example of Fig. 1, the portion 21 and the portion 22 are joined together directly. Alternatively, an intermediate portion (not shown in any of the figures) typically made of graphite can be interposed; this portion can, for example, be cylinder shaped, prismshaped, frustum of cone shaped or frustum of pyramid shaped. In this way, heat can flow by conduction from the portion 22 to the portion 21; therefore, these portions must be made of material that is a heat conductor.

In this example of Fig. 1, the ratio between the average diameter of the portion 21 and the average thickness of the portion 21 is a number comprised between 10 and 100.

In this example of Fig. 1, the ratio between the average diameter of the portion 21 and the average diameter of the portion 22 is a number comprised between 5 and 20.

In this example of Fig. 1, the ratio between the height of the portion 22 and the thickness of the portion 21 is a number comprised between 2 and 6.

In this example of Fig. 1, graphite was chosen not only as heat conducting material, but also as electrically conductive material (in particular provided with good susceptance); in fact, in this example according to the invention, both the portion 21 and the portion 22 are heated by electromagnetic induction. However, not according to the invention, the portion 21 and/or the portion 22 could be heated in a different way, for example through irradiation by lamps or conduction by resistors (this is valid particularly for the portion 22), and therefore the property of the material of being electrically conductive (in particular provided with good susceptance) could not be necessary for one or both of these portions.

A reaction chamber like the one shown partially in Fig. 1 is typically equipped with a cooling system, in particular, of the upper wall and of the lower wall; such cooling can be carried out through a flow of a fluid (for example liquid) for the lower wall and a flow of a fluid (for example gas and/or liquid) for the upper wall.

A reaction chamber like the one shown partially in Fig. 1 is typically equipped or associated with reflection devices for reflecting, in whole or in part, in particular infrared radiation emitted by the susceptor when it is hot, in particular during the epitaxial deposition processes.

A reaction chamber like the one shown partially in Fig. 1 can be equipped or associated with further temperature control devices (inside or outside the "reaction and deposition" zone).

An epitaxial reactor with a reaction chamber like the one shown partially in Fig. 1 is typically equipped with a handling system of the substrates to be treated and of the treated substrates; the handling system can be adapted to directly handle substrates or supports for substrates, like for example the support 3 in Fig. 1.

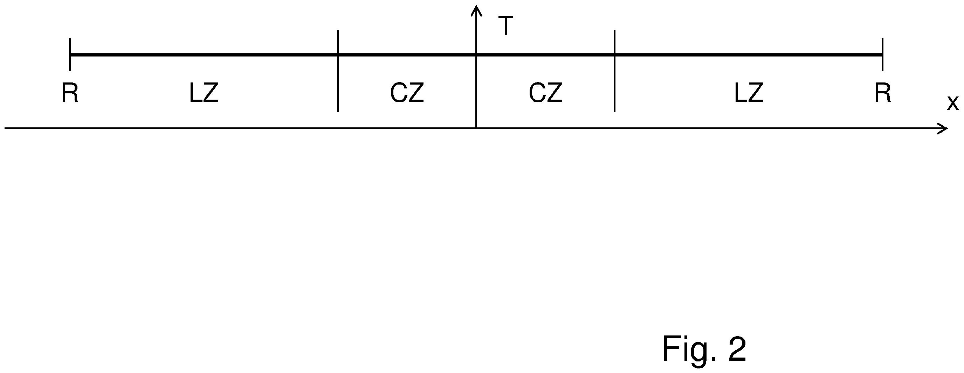

With reference to the example of Fig.1, ideally, the temperature T diagram of the upper face of the portion 21 as a function of the distance x from the axis Z is shown in Fig. 2; in such a figure, R corresponds to the radius of the disc-shaped portion 21. If the temperature of the upper face of the portion 21 is uniform (as shown in Fig. 2), the temperature of the upper face of the support 3, where the substrate(s) rest(s), is uniform. In any case, the mass of material of the support 3 (if present) can also contribute to making the temperature of the upper face of the support uniform.

It should be noted that, according to some embodiments, the preferred temperature T diagram of the upper face of the portion 21 as a function of the distance x from the axis Z could be, for example, slightly increasing or slightly decreasing or substantially constant. In Fig. 2 there is a central zone CZ of the temperature diagram and a side zone LZ of the temperature diagram, on the right and on the left of the zone CZ; as will be understood hereinafter, the temperature of an outer annular zone of the upper face of the portion 21 (substantially aligned with the zone LZ) is more influenced by a first inductor 4, in particular a flat inductor, and the temperature of a central zone of the upper face of the portion 21 (substantially aligned with the zone CZ) is more influenced by a second inductor 5, in particular a cylindrical inductor (thanks also, but not only, to the cylindrical portion 22 of the susceptor that transmits heat by conduction to the disc-shaped portion 21). A typical embodiment of a flat inductor consists of an electrical conductor arranged in the form of a (flat) spiral; a typical embodiment of a cylindrical inductor consists of a plurality of circular turns wound on a cylinder.

In first approximation, when both the inductor 4 and the inductor 5 are active, the power density in the susceptor (first transmitted as electromagnetic field, then converted into induced electrical current in the susceptor, and finally transformed into heat by Joule) effect due to two inductors feeding electrical currents is added; of course, not all of the electrical power supplied to the inductors becomes heat in the susceptor.

The distribution of the temperature in the susceptor depends essentially on four elements, i.e. the disc-shaped portion of the susceptor (21 in Fig. 1), the cylindrical portion of the susceptor (22 in Fig. 2), the first inductor (4 in Fig. 1) and the second inductor (5 in Fig. 1), and on various parameters of these elements; such parameters are mainly geometric, electrical and chemical (i.e. the materials of the components). The temperature is influenced, for example, also by any heat emitted by irradiation and absorbed by irradiation by the susceptor through its surfaces. Moreover, when the susceptor is inside a reaction chamber of an epitaxial deposition reactor (see for example Fig. 1), the temperature is influenced, for example, also by flows of gases in the reaction chamber and by flows of fluids (gaseous and/or liquid) outside of the reaction chamber. Finally, the temperature of the susceptor is influenced by the presence of a support with one or more substrates arranged on the susceptor.

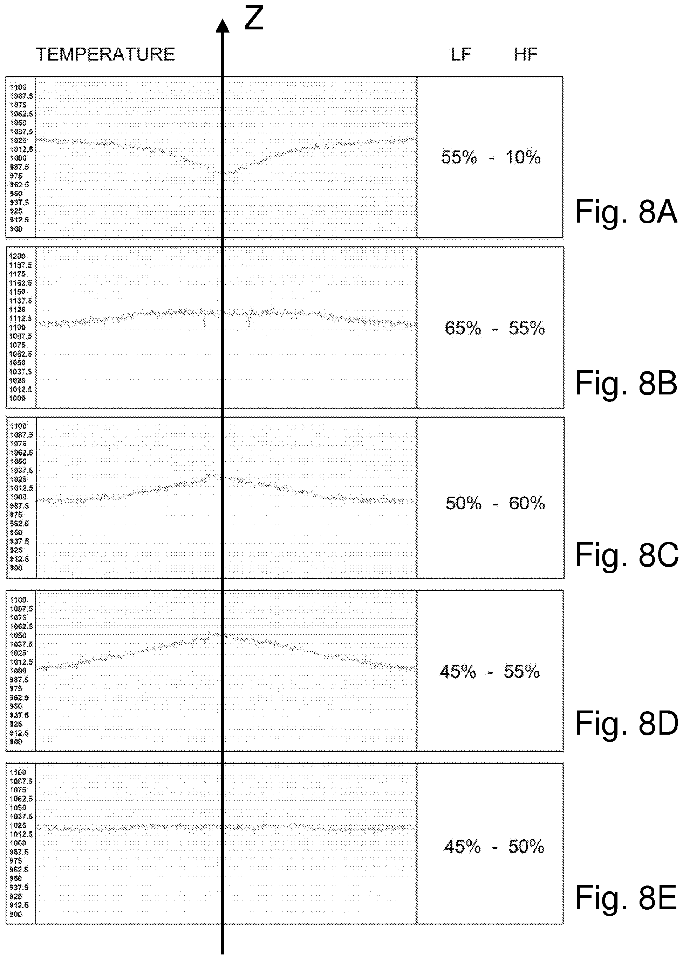

Fig. 8 shows (real) temperature diagrams relating to a susceptor very similar to that of Fig. 1 in five different heating conditions; precisely, it concerns the temperature in degrees Celsius of the upper face of the disc-shaped portion of the susceptor as a function of the distance from the central axis Z of symmetry of the susceptor. The diagrams of Fig. 8 derive from a set of experiments carried out using a first disc-shaped inductor power-supplied by a first LF generator of alternating electric voltage/current at low frequency (for example a frequency comprised in the range 2-4 KHz) and a second cylindrical inductor power-supplied by a second HF generator of alternating electric voltage/current at high frequency (for example a frequency comprised in the range 20-40 KHz); the first generator was capable of supplying at its output a maximum power of 40-50 KW and the output power was able to be set; the second generator was capable of supplying at its output a maximum power of 10-20 KW and the output power was able to be set. The temperature was detected through a thermographic camera.

In the first experiment, the electrical power supplied to the flat inductor was about 55% of the maximum power of the first LF generator and the electrical power supplied to the cylindrical inductor was about 10% of the maximum power of the second HF generator. As can be seen in Fig. 8A, the temperature diagram looks like an upturned Gaussian with a minimum at its centre of about 975°C and a maximum at its ends of about 1025°C.

In the second experiment, the electrical power supplied to the flat inductor was about 65% of the maximum power of the first LF generator and the electrical power supplied to the cylindrical inductor was about 55% of the maximum power of the second HF generator. As can be seen in Fig. 8B, the temperature diagram is like a portion of circumference with a maximum at its centre of about 1125°C (slightly less) and a minimum at its ends of about 1100°C (slightly more).

In the third experiment, the electrical power supplied to the flat inductor was about 50% of the maximum power of the first LF generator and the electrical power supplied to the cylindrical inductor was about 60% of the maximum power of the second HF generator. As can be seen in Fig. 8C, the temperature diagram is like a Gaussian with a maximum at its centre of about 1030°C and a minimum at its ends of about 990°C.

In the fourth experiment, the electrical power supplied to the flat inductor was about 45% of the maximum power of the first LF generator and the electrical power supplied to the cylindrical inductor was about 55% of the maximum power of the second HF generator. As can be seen in Fig. 8D, the temperature diagram is like a triangle with a maximum at its centre of about 1050°C and a minimum at its ends of about 1000°C.

In the fifth experiment, the electrical power supplied to the flat inductor was about 45% of the maximum power of the first LF generator and the electrical power supplied to the cylindrical inductor was about 50% of the maximum power of the second HF generator. As can be seen in Fig. 8E, the temperature diagram is like a portion of straight and horizontal line with an average value of about 1020°C.

The use of two inductors to heat the portion 21 thus allows greater flexibility in the control of its temperature.

In Fig. 1, all of the inductors are arranged under the reaction chamber; according to alternative solutions, one or each of the inductors could be arranged above the reaction chamber.

Essentially, the susceptor according to the present invention comprises a first disc-shaped portion and a second cylindrical or conical portion; equivalently, the second portion could be prismatic or pyramid-shaped. The cylindrical or conical portion is used in particular to heat the central zone of the disc-shaped portion in particular by conduction; for example, the disc-shaped portion can be heated directly by induction through a first inductor (or for example resistors); for example the cylindrical or conical portion can be heated directly by induction through a second inductor (or for example resistors).

Of course, the (direct) heating by induction of a part (or many parts) requires that such a part (or many parts) be made of a material adapted for such a type of heating, i.e. equipped with good susceptance.

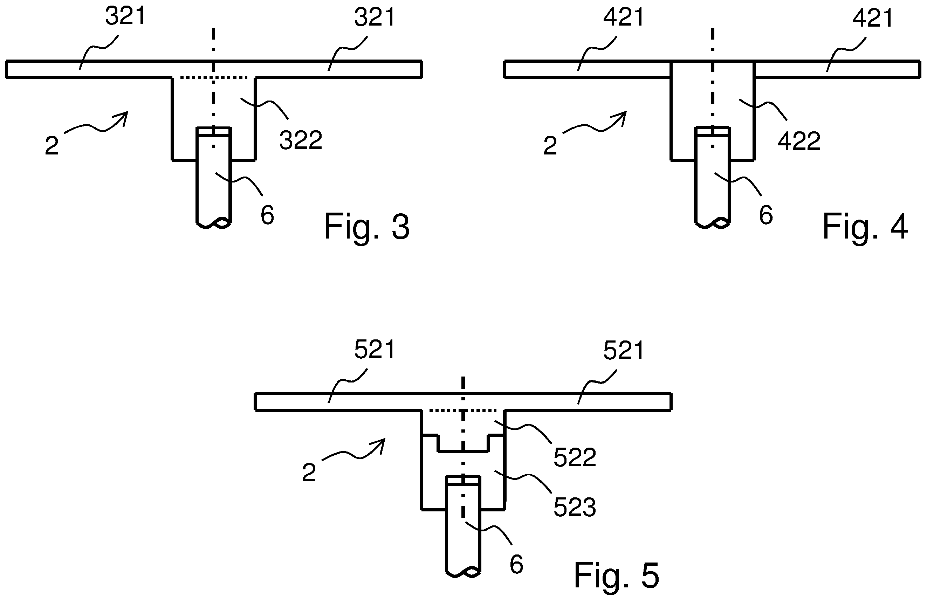

Figures 3, 4 and 5 schematically show three possible structures of the susceptor.

The disc-shaped portion of the susceptor is adapted to directly or indirectly support one or more substrates.

Typically and advantageously, the cylindrical or conical portion is coaxial to the disc-shaped portion; in particular, the axis of (substantial) symmetry of the cylindrical portion, the axis of (substantial) symmetry of the conical portion and the axis of (substantial) symmetry of the susceptor coincide.

Typically and advantageously, the cylindrical or conical portion is adjacent to the disc-shaped portion and in contact with it.

Typically and advantageously, the cylindrical or conical portion is located below the disc-shaped portion.

Typically and advantageously, the disc-shaped portion and the cylindrical or conical portion are made entirely of graphite (totally or partially coated with SiC and/or TaC).

In the susceptor 2 of Fig. 3, the disc-shaped portion 321 and the cylindrical or conical portion 322 are made in a single piece, i.e. the two portions are part of the same body. The portion 322 has a blind hole in which a drive shaft 6 screws that is used to make the susceptor 2 rotate; the shaft 6 can, for example, be made of steel (a material that is a good heat conductor and good electrical conductor) or of graphite (a material that is a fair heat conductor and a fair electrical conductor) or of ceramic (a material that is a poor heat conductor and a poor electrical conductor), taking due account of their mechanical properties; it should be noted that, if the shaft is made of graphite, this graphite could also be slightly different from the graphite of the susceptor, for example it could have lower heat conductivity.

In the susceptor 2 of Fig. 4, the disc-shaped portion 421 is made in a single first piece (for example made entirely of graphite totally or partially coated with SiC and/or TaC) and the cylindrical or conical portion 422 is made in a single second piece (for example made entirely of graphite totally or partially coated with SiC and/or TaC); the first piece and the second piece are fixed together. The portions 322 and 422 are substantially the same (axial) length. In such example, the attachment is carried out through a screw coupling; in particular, the portion 421 has a threaded through hole and the cylindrical or conical portion 422 is screwed in this hole. The portion 422 has a blind hole in which a drive shaft 6 is screwed that is used to make the susceptor 2 rotate; the shaft 6 can, for example, be made of steel (a material that is a good heat conductor and good electrical conductor) or of graphite (a material that is a fair heat conductor and a fair electrical conductor) or of ceramic (a material that is a poor heat conductor and a poor electrical conductor), taking due account of their mechanical properties; it should be noted that, if the shaft is made of graphite, this graphite could also be slightly different from the graphite of the susceptor, for example it could have lower heat conductivity.

In the susceptor 2 of Fig. 5, the disc-shaped portion 521 is substantially the same as the disc-shaped portion 321, whereas the cylindrical or conical portion 522 differs from the cylindrical or conical portion 322 in that it is shorter (axially); the reduced length of the portion 522 facilitates the insertion of the susceptor in a closed reaction chamber, i.e. already assembled. In order to supply heat to the central zone of the disc-shaped portion 521, it is useful to have a conical or cylindrical element that is long enough to be able to be coupled with a sufficiently long solenoid inductor; for this purpose, in addition to the cylindrical or conical portion 522 (for example made entirely of graphite totally or partially coated with SiC and/or TaC), a further cylindrical or conical portion 523 (for example made entirely of graphite totally or partially coated with SiC and/or TaC) has been provided in contact with it; the portions 522 and 523 are fixed together for example through a screw coupling. The portion 523 has a blind hole in which a drive shaft 6 is screwed that is used to make the susceptor 2 rotate; the shaft 6 can, for example, be made of steel (a material that is a good heat conductor and good electrical conductor) or of graphite (a material that is a fair heat conductor and a fair electrical conductor) or of ceramic (a material that is a poor heat conductor and a poor electrical conductor), taking due account of their mechanical properties; it should be noted that, if the shaft is made of graphite, this graphite could also be slightly different from the graphite of the susceptor, for example it could have lower heat conductivity.

The hole of the cylindrical or conical portions of figures 3, 4 and 5 is used to fix the drive shaft and to be able to transmit rotary movements to said disc-shaped portion through the cylindrical or conical portion.

However, a (blind or through) hole (for example a shaped hole) in the cylindrical or conical portion can also be used to influence the temperature profile of the upper face of the disc-shaped portion.

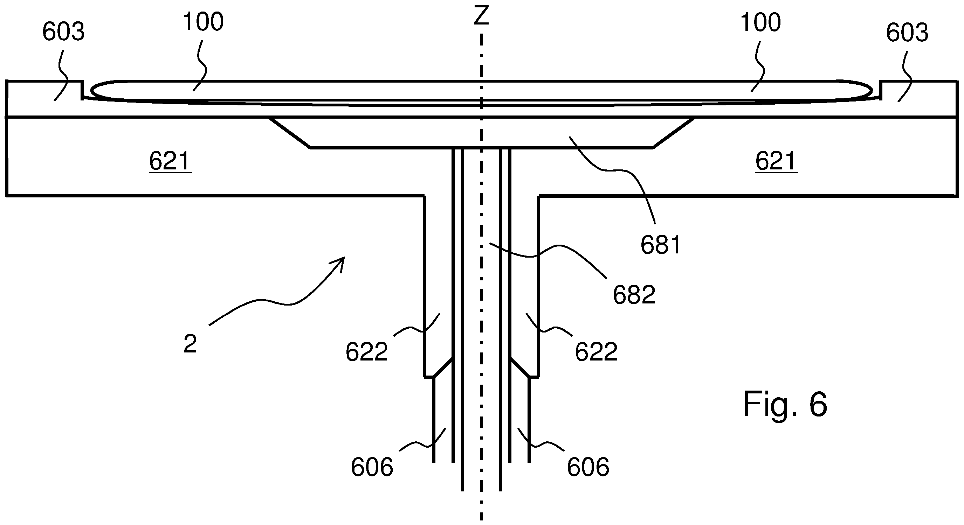

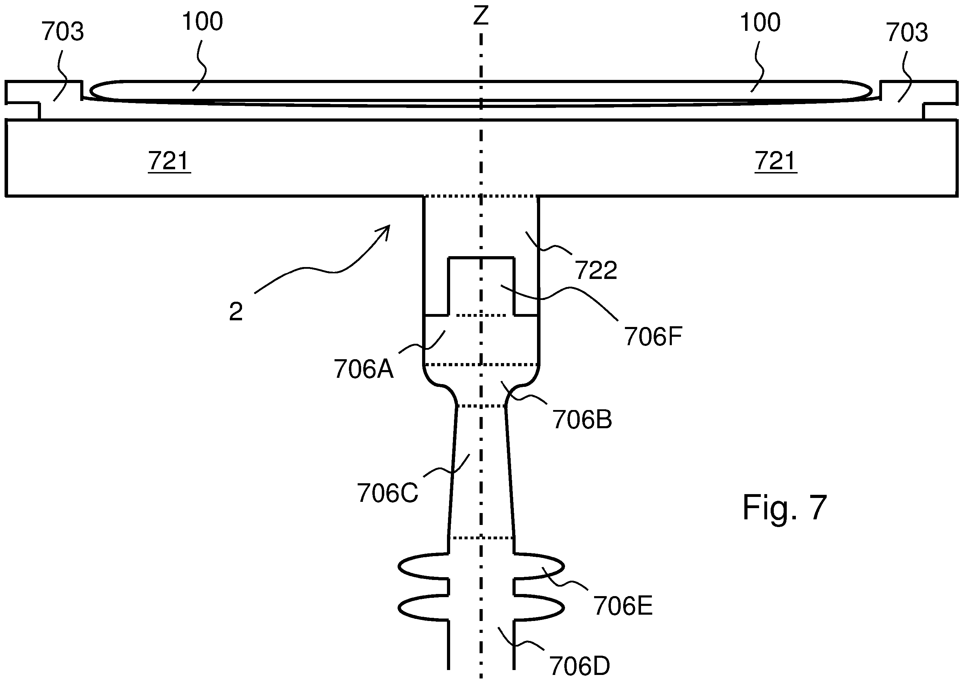

In the example of Fig. 1, there is a disc-shaped support 3 adapted to support one or more substrates and rested on the disc-shaped portion 21; in Fig. 6, such support, indicated with reference numeral 603 and rested on the disc-shaped portion 621, is shown in greater detail according to an embodiment suitable for a single substrate 100 at a time; in Fig. 7, such support, indicated with reference numeral 703 and rested on the disc-shaped portion 721, is shown in greater detail according to an embodiment suitable for a single substrate 100 at a time.

According to a variant of Fig. 1 and Fig. 6 and Fig. 7, the lower surface of the support 3 is perfectly flat, whereas the upper surface of the portion 21 is (slightly) concave centrally; this means that, when cold, although the support 3 is rested on the portion 21 the lower surface of the support 3 is not totally in contact with the upper surface of the portion 21, and that, when hot (during the epitaxial deposition processes), the lower surface of the support 3 is more in contact with the upper surface of the portion 21 in particular perfectly in contact.

In Fig. 6 and Fig. 7, the disc-shaped support 603/703 has a face that has a (thin) recess for a substrate 100 (alternatively a plurality of recesses for a corresponding plurality of substrates), substantially cylindrical in shape - the substrates can have so-called "flats". The recess can have a flat or (slightly) concave bottom. The recess typically has a solid bottom. It should be noted that a support that is the same as or similar to that of Fig. 6 and Fig. 7 can gradually deform, in particular become convex, process after process.

In Fig. 6 and Fig. 7, the substrate 100 has a diameter of 300 mm. It should be noted that the present invention has been specifically devised for reactors adapted for treating a single substrate at a time of large diameter, for example 200 mm and above (up to 450 mm).

In Fig. 7, the disc-shaped support 703 has a lower edged shaped to allow handling of the disc-shaped support 703 by a tool; alternatively, the disc-shaped portion 721 can have an upper edge shaped to allow handling of the disc-shaped support 703 by a tool; alternatively again, both the lower edge of the support 703 and the upper edge of the portion 721 can be shaped.

According to the example of Fig.6, the cylindrical or conical portion 622 of the susceptor 2 has a through hole, the disc-shaped portion 621 of the susceptor 2 has a seat, and there is a lifting device adapted for lifting substrates; the lifting device comprises a stem 682 and a plate 681 fixed together; the stem 682 is arranged in the through hole and adapted to slide along the through hole, and the plate 681 is arranged in the seat.

There is also a hollow drive shaft 606 fixed to the cylindrical or conical portion 622.

For indicative purposes, the outer diameter of the portion 622 and/or of the shaft 606 is 40-60 mm.

For indicative purposes, the rotation speed of the shaft 606 (and therefore of the portions 621 and 622) is 5-50 RPM.

According to the example of Fig.7, there is a drive shaft 706 fixed to the cylindrical or conical portion 722.

For indicative purposes, the outer diameter of the portion 722 is 40-60 mm.

For indicative purposes, the rotation speed of the shaft 706 (and therefore of the portions 721 and 722) is 5-50 RPM.

Preferably, the shaft 706 is made entirely of graphite, in particular due to the heat resistivity and the ability to withstand high temperatures of this material.

The shaft 706 comprises an upper portion 706A, a lower portion 706D and a possible intermediate portion 706C; the upper portion 706A and the possible intermediate portion 706C can be joined through a (smooth-) junction portion 706B. It should be noted that the arrangement of the portion 722 and of the portion 706A can be considered a single cylindrical element. In fact, in the example of Fig. 7, the inductor 5 can extend, for example, up to the lower end of the portion 706A; in other words, the inductor 5 can extend up to the lower end of the cylindrical or conical portion (722 in Fig.7) or slightly beyond, for example beyond by 1-3 cm until it covers the portion 706A of the shaft 706. The upper portion 706A can have a cylindrical or conical protrusion (706F in Fig. 7) or recess (not foreseen in Fig. 7) for the mechanical coupling with a corresponding cylindrical or conical recess or protrusion of the cylindrical or conical portion 722. According to the example of Fig. 7, the lower portion 706D has radial protrusions 706E for heat dissipation.

Fig. 1 shows some components that are not part of the reaction chamber in the strict sense, but that are typically part of an epitaxial reactor, in particular a first inductor 4 and a second inductor 5.

The first inductor 4 is adapted to directly heat the disc-shaped portion 21; this is, in particular, "flat" (i.e. equating its turns to a curved line, this lies entirely in one plane).

The second inductor 5 is adapted to directly heat the cylindrical or conical portion 22 and to indirectly heat the disc-shaped portion 21; this is, in particular, "cylindrical" (i.e. equating the turns of each winding thereof to a curved line, this lies entirely in a cylindrical surface). The inductor 5 can comprise two (or more) coaxial windings 51 and 52 (in the same direction) of turns to create more electromagnetic field in less length. According to variants of Fig. 1, the inductor 4 and/or the inductor 5 could be "shaped"; for example, the inductor 4 could not be perfectly flat and/or the inductor 5 could not be perfectly cylindrical. Moreover, the shape and/or the position of the inductor 4 and/or of the inductor 5 could be adjustable.

According to variants of Fig. 1, the inductor 4 and/or the inductor 5 could consist of a conductor having a section that varies as a function of the position.

The distribution of the electromagnetic field, and therefore the distribution of temperature, inside the disc-shaped portion of the susceptor, essentially depends on four elements, i.e. the disc-shaped portion (21 in Fig. 1), the cylindrical portion (22 in Fig. 2), the first inductor (4 in Fig. 1) and the second inductor (5 in Fig. 1), and on various parameters of these elements; such parameters are mainly geometric, electrical and chemical (i.e. the materials of the components).

Fig. 1 shows a separation element 7 adapted for reducing mutual induction between the first inductor 4 and the second inductor 5; this is arranged between the inductor 4 and the inductor 5, in particular it surrounds the inductor 5 (as well as the sleeve 13 and the portion 22); materials that can be used for this purpose are ferrites and MDMs [Magneto Dielectric Materials].

Typically the inductors 4 and 5 are completely disconnected from one another, the first and the second inductor 4 and 5 are adapted to be power-supplied independently, in particular at different frequencies for example to limit mutual interactions; for example, the frequency of one could be 2-4 KHz and the frequency of the other 20-40 KHz; for example the ratio between the frequencies could be equal to a number comprised between 5 and 20.

The first inductor 4 can be adapted to be adjusted through modification of its position and/or through modification of the mutual position of its turns; the modification can be manual or motorised or automatic.

The second inductor 5 can be adapted to be adjusted through modification of its position and/or through modification of the mutual position of its turns; the modification can be manual or motorised or automatic.

## Claims

1. Epitaxial deposition reactor comprising at least one susceptor;
wherein the susceptor comprises a disc-shaped portion (21) with an upper zone and a lower zone and a cylindrical or conical portion (22) with an upper zone and a lower zone, said disc-shaped portion (21) being adapted to directly or indirectly support (3) one or more substrates on said upper zone;
wherein said disc-shaped portion (21) and said cylindrical or conical portion (22) are coaxial;
wherein the lower zone of said disc-shaped portion (21) and the upper zone of said cylindrical or conical portion (22) are joined together directly or through a possible intermediate portion so that heat can flow by conduction from said cylindrical or conical portion (22) to said disc-shaped portion (21);
wherein said disc-shaped portion (21) and said cylindrical or conical portion (22) and said possible intermediate portion are made entirely of a material that is a heat conductor, preferably graphite;
wherein the epitaxial deposition reactor comprises further a first inductor (4) adapted to directly heat said disc-shaped portion (21) by electromagnetic induction, a second inductor (5) adapted to directly heat said cylindrical or conical portion (22) by electromagnetic induction and indirectly heat said disc-shaped portion (21), and means for supplying power to said first and second inductors (4, 5);
wherein said first inductor (4) is flat;
wherein said second inductor (5) is cylindrical or conical;
wherein said first and second inductors (4, 5) are adapted to be power-supplied by said means independently at different frequencies.

2. Epitaxial deposition reactor according to claim 1, wherein said disc-shaped portion (21) and/or said cylindrical or conical portion (22) are made entirely of a material that is electrically conductive suitable for being heated by electromagnetic induction, preferably graphite.

3. Epitaxial deposition reactor according to claim 1 or 2, wherein said disc-shaped portion (321) and said cylindrical or conical portion (322) and said possible intermediate portion are made in a single piece.

4. Epitaxial deposition reactor according to claim 1 or 2, wherein said disc-shaped portion (421) is made in a single first piece and said cylindrical or conical portion (422) is made in a single second piece, wherein said first and second pieces are fixed to one another.

5. Epitaxial deposition reactor according to any one of claims 1 to 4, wherein said cylindrical or conical portion (322, 422) has a hole.

6. Epitaxial deposition reactor according to any one of claims 1 to 5, comprising a drive shaft (6) coupled with said cylindrical or conical portion (322, 422, 522), in particular with the lower zone of said cylindrical or conical portion, and adapted to transmit rotary movements to said disc-shaped portion (321, 421, 521) through said cylindrical or conical portion (322, 422, 522).

7. Epitaxial deposition reactor according to any one of claims 1 to 6, also comprising a disc-shaped support (3, 603) adapted to directly support one or more substrates (100) and rested on said disc-shaped portion (21, 621).

8. Epitaxial deposition reactor according to claim 7, wherein said disc-shaped support (603) has a shaped lower edge and/or said disc-shaped portion (621) has a shaped upper edge, to allow handling of said disc-shaped support (603) by a tool.

9. Epitaxial deposition reactor according to any one of claims 1 to 8, wherein said cylindrical or conical portion (622) has a through hole, wherein said disc-shaped portion (621) has a seat, and comprising a lifting device adapted to lift substrates, wherein said lifting device comprises a stem (682) and a plate (681) fixed to one another, wherein said stem (682) is arranged in said through hole and adapted to slide along said through hole, wherein said plate (681) is arranged in said seat.

10. Epitaxial deposition reactor according to any one of claims 1 to 9, wherein the ratio between the different frequencies is in the range from 5 to 20.

11. Epitaxial deposition reactor according to any one of claims 1 to 10,
wherein the frequency used for the disc-shaped portion (21) is in the range from 2 KHz to 4 KHz; and/or
wherein the frequency used for the cylindrical or conical portion (22) is in the range from 20 KHz to 40 KHz.

12. Epitaxial deposition reactor according to any one of claims 1 to 11,
wherein said first inductor (4) is adapted to be adjusted through modification of its position and/or through modification of the mutual position of its turns, and/or
wherein said second inductor (5) is adapted to be adjusted through modification of its position and/or through modification of the mutual position of its turns.

## Patentansprüche

1. Epitaxialer Abscheidungsreaktor mit mindestens einem Suszeptor;
wobei der Suszeptor einen scheibenförmigen Abschnitt (21) mit einer oberen Zone und einer unteren Zone und einen zylindrischen oder konischen Abschnitt (22) mit einer oberen Zone und einer unteren Zone umfasst, wobei der scheibenförmige Abschnitt (21) angepasst ist, um direkt oder indirekt ein oder mehrere Substrate auf der oberen Zone zu tragen (3);
wobei der scheibenförmige Abschnitt (21) und der zylindrische oder konische Abschnitt (22) koaxial sind;
wobei die untere Zone des scheibenförmigen Abschnitts (21) und die obere Zone des zylindrischen oder konischen Abschnitts (22) direkt oder durch einen möglichen Zwischenabschnitt miteinander verbunden sind, so dass Wärme durch Leitung von dem zylindrischen oder konischen Abschnitt (22) zu dem scheibenförmigen Abschnitt (21) fließen kann;
wobei der scheibenförmige Abschnitt (21) und der zylindrische oder konische Abschnitt (22) und der mögliche Zwischenabschnitt vollständig aus einem wärmeleitenden Material, vorzugsweise Graphit, bestehen;
wobei der Reaktor für die epitaxiale Abscheidung ferner einen ersten Induktor (4), der so beschaffen ist, dass er den scheibenförmigen Abschnitt (21) durch elektromagnetische Induktion direkt erwärmt, einen zweiten Induktor (5), der so beschaffen ist, dass er den zylindrischen oder konischen Abschnitt (22) durch elektromagnetische Induktion direkt erwärmt und den scheibenförmigen Abschnitt (21) indirekt erwärmt, sowie Mittel zur Stromversorgung des ersten und des zweiten Induktors (4, 5) umfasst;
wobei der erste Induktor (4) flach ist;
wobei der zweite Induktor (5) zylindrisch oder konisch ist;
wobei der erste und der zweite Induktor (4, 5) so beschaffen sind, dass sie von den genannten Mitteln unabhängig voneinander mit unterschiedlichen Frequenzen mit Strom versorgt werden können.

2. Epitaxialer Abscheidungsreaktor nach Anspruch 1, wobei der scheibenförmige Abschnitt (21) und/oder der zylindrische oder konische Abschnitt (22) vollständig aus einem Material hergestellt sind, das elektrisch leitfähig ist und durch elektromagnetische Induktion erwärmt werden kann, vorzugsweise aus Graphit.

3. Epitaxialer Abscheidungsreaktor nach Anspruch 1 oder 2, wobei der scheibenförmige Abschnitt (321) und der zylindrische oder konische Abschnitt (322) und der mögliche Zwischenabschnitt aus einem einstückigen Teil bestehen.

4. Epitaxialer Abscheidungsreaktor nach Anspruch 1 oder 2, wobei der scheibenförmige Abschnitt (421) aus einem ersten einstückigen Teil besteht und der zylindrische oder konische Abschnitt (422) aus einem zweiten einstückigen Teil besteht, wobei das erste und das zweite Teil aneinander befestigt sind.

5. Epitaxialer Abscheidungsreaktor nach einem der Ansprüche 1 bis 4, wobei der zylindrische oder konische Abschnitt (322, 422) ein Loch aufweist.

6. Epitaxialer Abscheidungsreaktor nach einem der Ansprüche 1 bis 5, umfassend eine Antriebswelle (6), die mit dem zylindrischen oder konischen Abschnitt (322, 422, 522), insbesondere mit der unteren Zone des zylindrischen oder konischen Abschnitts, gekoppelt ist und so beschaffen ist, dass er Drehbewegungen auf den scheibenförmigen Abschnitt (321, 421, 521) über den zylindrischen oder konischen Abschnitt (322, 422, 522) überträgt.

7. Epitaxialer Abscheidungsreaktor nach einem der Ansprüche 1 bis 6, ferner umfassend einen scheibenförmigen Träger (3, 603), der so beschaffen ist, dass er ein oder mehrere Substrate (100) direkt trägt und auf dem scheibenförmigen Abschnitt (21, 621) ruht.

8. Epitaxialer Abscheidungsreaktor nach Anspruch 7, wobei der scheibenförmige Träger (603) eine geformte untere Kante und/oder der scheibenförmige Abschnitt (621) eine geformte obere Kante aufweist, um die Handhabung des scheibenförmigen Trägers (603) durch ein Werkzeug zu ermöglichen.

9. Epitaxialer Abscheidungsreaktor nach einem der Ansprüche 1 bis 8, wobei der zylindrische oder konische Abschnitt (622) ein Durchgangsloch aufweist, wobei der scheibenförmige Abschnitt (621) einen Sitz aufweist und eine Hebevorrichtung umfasst, die so beschaffen ist, dass sie die Substrate anhebt, wobei die Hebevorrichtung einen Schaft (682) und eine Platte (681) umfasst, die aneinander befestigt sind, wobei der Schaft (682) in dem Durchgangsloch angeordnet ist und so beschaffen ist, dass er entlang des Durchgangslochs gleitet, wobei die Platte (681) in dem Sitz angeordnet ist.

10. Epitaxialer Abscheidungsreaktor nach einem der Ansprüche 1 bis 9, wobei das Verhältnis zwischen den verschiedenen Frequenzen im Bereich von 5 bis 20 liegt.

11. Epitaxialer Abscheidungsreaktor nach einem der Ansprüche 1 bis 10,
wobei die für den scheibenförmigen Abschnitt (21) verwendete Frequenz im Bereich von 2 KHz bis 4 KHz liegt; und/oder
wobei die für den zylindrischen oder konischen Abschnitt (22) verwendete Frequenz im Bereich von 20 KHz bis 40 KHz liegt.

12. Epitaxialer Abscheidungsreaktor nach einem der Ansprüche 1 bis 11,
wobei der erste Induktor (4) geeignet ist, durch Änderung seiner Position und/oder durch Änderung der gegenseitigen Position seiner Windungen eingestellt zu werden, und/oder
wobei der zweite Induktor (5) geeignet ist, durch Änderung seiner Position und/oder durch Änderung der gegenseitigen Position seiner Windungen eingestellt zu werden.

## Revendications

1. Réacteur de dépôt épitaxial comprenant au moins un suscepteur ;
dans lequel le suscepteur comprend une partie en forme de disque (21) avec une zone supérieure et une zone inférieure et une partie cylindrique ou conique (22) avec une zone supérieure et une zone inférieure, ladite partie en forme de disque (21) étant apte à supporter directement ou indirectement (3) un ou plusieurs substrats sur ladite zone supérieure ;
dans lequel ladite partie en forme de disque (21) et ladite partie cylindrique ou conique (22) sont coaxiales ;
dans lequel la zone inférieure de ladite partie en forme de disque (21) et la zone supérieure de ladite partie cylindrique ou conique (22) sont jointes ensemble directement ou à travers une éventuelle partie intermédiaire de sorte que la chaleur puisse s'écouler par conduction de ladite partie cylindrique ou conique (22) à ladite partie en forme de disque (21) ;
dans lequel ladite partie en forme de disque (21) et ladite partie cylindrique ou conique (22) et ladite éventuelle partie intermédiaire sont entièrement constituées d'un matériau qui est un conducteur de chaleur, de préférence du graphite ;
dans lequel le réacteur de dépôt épitaxial comprend en outre un premier inducteur (4) apte à chauffer directement ladite partie en forme de disque (21) par induction électromagnétique, un second inducteur (5) apte à chauffer directement ladite partie cylindrique ou conique (22) par induction électromagnétique et chauffer indirectement ladite partie en forme de disque (21), et des moyens pour fournir de l'énergie auxdits premier et second inducteurs (4, 5) ; dans lequel ledit premier inducteur (4) est plat ;
dans lequel ledit second inducteur (5) est cylindrique ou conique ;
dans lequel lesdits premier et second inducteurs (4, 5) sont aptes à être alimentés en énergie par lesdits moyens de manière indépendante à des fréquences différentes.

2. Réacteur de dépôt épitaxial selon la revendication 1, dans lequel ladite partie en forme de disque (21) et/ou ladite partie cylindrique ou conique (22) sont entièrement constituées d'un matériau qui est électriquement conducteur adapté pour être chauffé par induction électromagnétique, de préférence du graphite.

3. Réacteur de dépôt épitaxial selon la revendication 1 ou 2, dans lequel ladite partie en forme de disque (321) et ladite partie cylindrique ou conique (322) et ladite éventuelle partie intermédiaire sont réalisées en une seule pièce.

4. Réacteur de dépôt épitaxial selon la revendication 1 ou 2, dans lequel ladite partie en forme de disque (421) est réalisée en une seule première pièce et ladite partie cylindrique ou conique (422) est réalisée en une seule seconde pièce, dans lequel lesdites première et seconde pièces sont fixées l'une à l'autre.

5. Réacteur de dépôt épitaxial selon l'une quelconque des revendications 1 à 4, dans lequel ladite partie cylindrique ou conique (322, 422) comporte un trou.

6. Réacteur de dépôt épitaxial selon l'une quelconque des revendications 1 à 5, comprenant un arbre d'entraînement (6) couplé à ladite partie cylindrique ou conique (322, 422, 522), en particulier à la zone inférieure de ladite partie cylindrique ou conique, et apte à transmettre des mouvements de rotation à ladite partie en forme de disque (321, 421, 521) à travers ladite partie cylindrique ou conique (322, 422, 522).

7. Réacteur de dépôt épitaxial selon l'une quelconque des revendications 1 à 6, comprenant également un support en forme de disque (3, 603) apte à supporter directement un ou plusieurs substrats (100) et reposant sur ladite partie en forme de disque (21, 621).

8. Réacteur de dépôt épitaxial selon la revendication 7, dans lequel ledit support en forme de disque (603) comporte un bord inférieur conformé et/ou ladite partie en forme de disque (621) comporte un bord supérieur conformé, pour permettre la manipulation dudit support en forme de disque (603) par un outil.

9. Réacteur de dépôt épitaxial selon l'une quelconque des revendications 1 à 8, dans lequel ladite partie cylindrique ou conique (622) comporte un trou traversant, dans lequel ladite partie en forme de disque (621) comporte un siège, et comprenant un dispositif de levage apte à lever des substrats, dans lequel ledit dispositif de levage inclut une tige (682) et une plaque (681) fixées l'une à l'autre, dans lequel ladite tige (682) est disposée dans ledit trou traversant et apte à coulisser le long dudit trou traversant, dans lequel ladite plaque (681) est disposée dans ledit siège.

10. Réacteur de dépôt épitaxial selon l'une quelconque des revendications 1 à 9, dans lequel le rapport entre les différentes fréquences est dans la plage de 5 à 20.

11. Réacteur de dépôt épitaxial selon l'une quelconque des revendications 1 à 10,
dans lequel la fréquence utilisée pour la partie en forme de disque (21) est dans la gamme de 2 KHz à 4 KHz ; et/ou
dans lequel la fréquence utilisée pour la partie cylindrique ou conique (22) est dans la gamme de 20 KHz à 40 KHz.

12. Réacteur de dépôt épitaxial selon l'une quelconque des revendications 1 à 11,
dans lequel ledit premier inducteur (4) est apte à être ajusté par modification de sa position et/ou par modification de la position mutuelle de ses tours, et/ou
dans lequel ledit second inducteur (5) est apte à être ajusté par modification de sa position et/ou par modification de la position mutuelle de ses tours.
